# EUROPÄISCHE PATENTSCHRIFT

(11) **EP 1 518 890 B1**
(45) Veröffentlichungstag und Bekanntmachung des Hinweises auf die Patenterteilung: **14.05.2008**
(21) Anmeldenummer: 04017813.9
(22) Anmeldetag: 28.07.2004
(51) Int. Cl.: C08K 3/00, C08K 9/06

(54) **Härtbares Reaktionsharzsystem**
Curable reactive resin system
Système durcissable de résine réactive

(30) Priorität: 30.09.2003 DE 10345312; 29.09.2003 DE 10345139
(43) Veröffentlichungstag der Anmeldung: 30.03.2005
(73) Patentinhaber: ROBERT BOSCH GMBH, 70442 Stuttgart (DE)
(72) Erfinder: Jennrich, Irene, 71364 Winnenden (DE); Leo, Kristian, 71576 Burgstetten (DE); Muzic, Markus, 71711 Murr (DE); Endres, Wolfgang, 73630 Remshalden (DE); Holst, Marco, 70197 Stuttgart (DE)

(56) Entgegenhaltungen:
- EP-A- 0 136 257
- EP-A- 0 426 482
- WO-A-97/39043
- US-A- 3 515 625
- US-A- 5 910 523
- US-A1- 2003 083 401

## Beschreibung

### Stand der Technik

Die Erfindung bezieht sich auf ein epoxidfreies härtbares Reaktionsharzsystem und ein Verfahren zur Herstellung derselben sowie dessen Verwendung nach dem Oberbegriff der unabhängigen Ansprüche.

Systeme auf der Basis eines durch eine chemische Reaktion aushärtenden Harzes spielen bei der Herstellung technischer Bauteile und Komponenten eine große Rolle. Werden derartige Reaktionsharzsysteme zu Isolierzwecken eingesetzt, so weisen diese üblicherweise hohe Füllstoffgehalte auf. Hohe Füllstoffgehalte führen zu einer hohen thermischen und mechanischen Beständigkeit der ausgehärteten Reaktionsharzsysteme.

Üblicherweise sind derartige Reaktionsharzsysteme als Zweikomponentensysteme ausgeführt, wobei die eine Komponente ein Härter ist, der mit der anderen Komponente, die Reaktionsharze, Füllstoffe etc. enthält, gemischt und sofort verarbeitet wird. Dies ist nachteilig, da die Bereitstellung des Reaktionsharzsystems in den Verarbeitungsprozess integriert werden muss und eine Lagerung für beispielsweise 3 bis 12 Monate in einsatzfähigem Zustand bei Raumtemperatur nicht möglich ist.

Eine weitere Möglichkeit besteht in der Verwendung einkomponentiger Reaktionsharzsysteme. So sind aus der DE 101 44 871 A1 einkomponentige Reaktionsharzsysteme auf der Basis von Epoxidharzen bekannt. Diese weisen einen Füllstoffanteil von bis zu 85 Gew.% auf. Höhere Füllstoffanteile sind zwar erwünscht, da sie zu einer hohen thermischen und mechanischen Beständigkeit des Reaktionsharzsystems im ausgehärteten Zustand führen, sie sind mit den dort beschriebenen Systemen jedoch nicht realisierbar, da es sonst zu nachteiligen Auswirkungen auf die Viskosität bzw. Verarbeitbarkeit der Vergussmasse kommt. Ein Problem stellt weiterhin die physiologische Bedenklichkeit von epoxidhaltigen Systemen dar, die einen erhöhten Aufwand hinsichtlich einer ausreichenden Arbeitssicherheit im Umgang damit bedingen.

Der vorliegenden Erfindung liegt die Aufgabe zugrunde, ein epoxidfreies härtbares Reaktionsharzsystem bereitzustellen, das eine hohe thermische und mechanische Beständigkeit aufweist und dennoch gut zu verarbeiten ist.

### Vorteile der Erfindung

Die der Erfindung zugrundeliegende Aufgabe wird erfindungsgemäß durch die Bereitstellung eines Reaktionsharzsystems mit den kennzeichnenden Merkmalen des Anspruchs 1 gelöst. Das Reaktionsharzsystem ist als Ein- oder Zweikomponentensystem einsetzbar und enthält als FüllstoffNanopartikel. Durch die Verwendung von Nanopartikeln als Füllstoff können Reaktionsharzsysteme realisiert werden, die einen Füllstoffanteil von bis zu 90 Gew.% aufweisen und dennoch gieß- bzw. imprägnierfähig sind. Auf diese Weise wird ein thermisch und mechanisch hoch belastbares System geschaffen. Das Reaktionsharzsystem zeichnet sich im ausgehärteten Zustand durch eine höhere Bruchdehnung, einen geringen thermischen Ausdehnungskoeffizienten sowie eine hohe Abriebfestigkeit und Wärmeleitfähigkeit aus.

Mit den in den Unteransprüchen aufgeführten Maßnahmen sind vorteilhafte Weiterbildungen des erfindungsgemäßen Reaktionsharzsystems möglich.

So ist es von Vorteil, wenn das Reaktionsharzsystem als Einkomponentensystem ausgeführt ist, da dies eine vereinfachte Verarbeitung derselben im Produktionsprozess ermöglicht. Weiterhin weist das Reaktionsharzsystem vorzugsweise als Füllstoff Quarzgut- oder Quarzmehlpartikel auf, die zu einer besonders ausgeprägten thermischen Stabilität sowie zu einem kleinen Ausdehnungskoeffzienten bzw. zu einer geringen Dielektrizitätskonstante führen. Besonders vorteilhaft ist dabei die Verwendung oberflächenmodifizierter Nanopartikel.

Eine weitere vorteilhafte Ausführungsform besteht darin, dass der Füllstoff Partikel zweier unterschiedlicher Korngrößenverteilungen aufweist, wobei eine Korngrößenverteilung im Nanometerbereich liegt. Darüber hinaus ist es von Vorteil, wenn das Reaktionsharzsystem im Harz dispergierte Polymerpartikel in Form von Silikonelastomerpartikel oder Elastomerpartikel eines Polyesters enthalten.

In einer besonders vorteilhaften Ausführung weist das Reaktionsharzsystem in der Harzkomponente dispergierte Elastomerpartikel mit einem Teilchendurchmesser von 10 nm bis 100 µm auf. Der Zusatz von Elastomerpartikeln als sogenannte Modifier bewirkt, dass das Reaktionsharzsystem aufgrund seines hohen Vernetzungsgrades spröde.wird.

### Ausführungsbeispiele

Ein Reaktionsharzsystem gemäß der vorliegenden Erfindung weist drei Grundkomponenten auf, nämlich eine Harzkomponente A, einen Füllstoff B und Polymerpartikel C auf, die in der Harzkomponente A dispergiert sind. Darüber hinaus sind weitere Komponenten vorgesehen, wie beispielsweise ein oder mehrere Entschäumer, Sedimentationshemmer oder Haftvermittler.

Allgemein ist zu beachten, dass das Reaktionsharzsystem vor und während der Verarbeitung ein stabiles System bilden muss, um eine Entmischung der Komponenten zu verhindern. So sollten die Füllstoffpartikel B bzw. Polymerpartikel C stabile Dispersionen mit der Harzkomponente A bilden und, sofern mehrere Harzkomponenten A vorliegen, die Harzkomponenten A stabile Lösungen oder Emulsionen untereinander. Diese Stabilität muss sowohl während der Verarbeitung als auch bei der Aushärtung des Reaktionsharzsystems gewährleistet sein.

Als Harzkomponente A kann grundsätzlich eine Vielzahl monomerer, vernetzbarer Verbindungen oder Mischungen derartiger Verbindungen verwendet werden. Besonders vorteilhaft ist die Verwendung von Verbindungen, die Polymere mit Amid- oder ImidFunktionalitäten in der Polymerhauptkette bilden, wie beispielsweise Polyamide, Polyimide, Polyamidimide, Harnstoffharze, Melaminharze, Cyanatester und/oder Polyurethane. Unter Cyanatester werden Polykondensate aus organischen Dicyanaten mit ein- oder mehrwertigen Alkoholen verstanden.

Weiterhin sind als Harzkomponente A Verbindungen geeignet, die Polymere mit Carbonsäureesterfunktionalitäten in der Polymerhauptkette bilden, wie beispielsweise Alkydharze, Acrylate, Polyester oder Polyesterimide. Darüber hinaus sind auch Phenol- oder Silikonharze, Cellulosederrivate oder Vinyl- sowie Formaldehydharze geeignet. Unter den Phenolharzen sind dabei insbesondere Novolake und Resole geeignet. Die Harzkomponente A kann eine oder mehrere der genannten Verbindungen umfassen sowie weitere Harzkomponenten. Die Harzkomponente A ist im Reaktionsharzsystem zu 5 bis 95 Gew.%, vorzugsweise zu 10 bis 60 Gew.%, insbesondere zu 12 bis 28 Gew.% enthalten.

Die Reaktionsharzsystem enthält weiterhin einen Füllstoff B, durch dessen geeignete Wahl ein Schwund des Reaktionsharzsystems im ausgehärteten Zustand verringert werden kann und durch den sich die thermische Stabilität, Wärmeleitfähigkeit, Oberflächenhärte bzw. Rissfestigkeit des Reaktionsharzsystems im ausgehärteten Zustand erhöht. Der Füllstoff B enthält Nanopartikel, wobei unter Nanopartikel eine Teilchenfraktion zu verstehen ist, deren mittlere Korngrößenverteilung d₅₀ sich im Nanometerbereich bewegt. Als Füllstoffmaterialien eignen sich beispielsweise Quarz, Aluminiumoxid, Kreide, Siliziumcarbid, Bornitrid, Ruß oder Talkum. Vorzugsweise weist der Füllstoff B Partikel aus Quarzmehl bzw. Quarzgut oder Mischungen derselben auf. In einer besonders bevorzugten Ausführungsform weist der Füllstoff B Partikel zweier unterschiedlicher Korngrößenverteilungen d₅₀ auf. Dabei ist ein erster Teil der Füllstoffpartikel durch eine Korngrößenverteilung im Nanometerbereich charakterisiert und ein zweiter Teil der Füllstoffpartikel durch eine Korngrößenverteilung d₅₀ vorzugsweise im Mikrometerbereich. Alternativ kann der Füllstoff B zusätzlich Fasern, beispielsweise aus Glas oder Kohlenstoff enthalten. Dies ermöglicht den Einsatz des Reaktionsharzsystems bei der Herstellung von Sportgeräten oder Leiterplatten.

Durch die Verwendung von Nanopartikeln ist es möglich, den Gesamtanteil an Füllstoff B innerhalb des Reaktionsharzsystems bis auf 90 Gew.% zu erhöhen, wobei das Reaktionsharzsystem dennoch während des Verarbeitungs- bzw. Aushärtungsvorganges ausreichend fließfähig bleibt. Der gesamte Füllstoffanteil im Reaktionsharzsystem kann somit 2 bis 90 Gew.%, vorzugsweise 2 bis 70 Gew.% betragen, insbesondere 2 bis 25 Gew.%.

Als besonders geeignet hat sich die Verwendung silanisierter Füllstoffpartikel erwiesen, da durch eine Oberflächenmodifizierung der Füllstoffpartikel eine verbesserte Anbindung des Füllstoffs B an die Harzmatrix A des Reaktionsharzsystems gewährleistet ist. Um den Silanisierungsgrad des Füllstoffs B einstellen zu können, wird der Füllstoff entweder vorab mit einem Silanisierungsmittel behandelt und der vorsilanisierte Füllstoff dem Reaktionsharzsystem zugemischt; oder das Silanisierungsmittel wird dem Reaktionsharzsystem zugesetzt und die eigentliche Silanisierungsreaktion läuft im Reaktionsharzsystem ab. Alternativ kann der Füllstoff B auch eine chemisch modifizierte Oberfläche in Form einer Polymerschicht beispielsweise aus PE oder PP aufweisen.

Als dritte Komponente C enthält das Reaktionsharzsystem darüber hinaus in der Harzkomponente A dispergierte Polymerpartikel. Dabei handelt es sich insbesondere um Elastomerpartikel, wobei polysiloxanhaltige Elastomerpartikel bzw. Siliconpartikel, Elastomerpartikel aus einem Polyester oder Elastomerpartikel aus einem AcrylnitrilButadien-Styrol-Copolymerisat (ABS) bevorzugt sind. Die Komponente C stellt vorzugsweise eine Dispersion von Elastomerpartikeln in der Harzkomponente A dar. Die Elastomerpartikel weisen vorzugsweise einen Teilchendurchmesser von 10 nm bis 100 µm auf.

Die Silikonpartikel können grundsätzlich ebenfalls eine chemisch modifizierte Oberfläche in Form einer Polymerschicht beispielsweise aus PMMA aufweisen.

Das Reaktionsharzsystem enthält bis zu 25 Gew.% an Polymerpartikeln C, bevorzugt sind bis zu 10 Gew.%.

Um zu gewährleisten, dass die Reaktionsharzsystem als Einkomponentensystem verarbeitbar ist, ist als vierte Komponente beispielsweise ein Initiator D vorgesehen, der eine ausreichend rasche Reaktion bei höherer Temperatur ermöglicht. Derartige Initiatoren sind beispielsweise kationischer Art wie Iodonium-, Bor-Iodonium- oder Chinoliniumverbindungen. Weiterhin sind Peroxide, Verbindungen mit labilen Kohlenstoff-Kohlenstoff-Bindungen, Octoate® (ein Kautschuk-Aktivator auf der Basis von Zinkdiethylhexoat) oder organometallische Verbindungen auf der Basis von Zirkonium, Blei, Cobalt, Mangan oder Chrom sowie Ethyhexanoat geeignet.

Der Initiator kann darüber hinaus einen Cokatalysator enthalten, der vor allem der Senkung der Starttemperatur der Reaktion dient. Dieser kann ein Radikalbildner wie beispielsweise Benzopinakol sein. Die Wahl des Initiators bestimmt im wesentlichen den Reaktionsverlauf der Aushärtung. Die Kombination eines kationischen Vernetzers mit einem Cokatalysator führt zu einem geeigneten Reaktionsgeschwindigkeitsprofil, das durch eine eng einzugrenzende optimale Reaktionstemperatur gekennzeichnet ist, bei der die Reaktion zügig fortschreitet, ohne dass bereits bei tieferen Temperaturen wie beispielsweise Raumtemperatur eine schleppende Reaktion einsetzt. Dies ist darüber hinaus eine Voraussetzung für die Lagerfähigkeit des Einkomponentensystems bei Raumtemperatur.

Eine weitere Möglichkeit besteht in der Ausbildung des Reaktionsharzsystems als Zweikomponentensystem. Dabei besteht eine erste Komponente aus dem Initiator in Mischung mit der Harzkomponente A und gegebenenfalls dem mineralischen Füllstoff (B) und/oder den in der Harzkomponente (A) dispergierten Polymerpartikeln (C) und die zweite Komponente aus einem Cokatalysator in Mischung mit der Harzkomponente A und gegebenenfalls dem mineralischen Füllstoff (B) und/oder den in der Harzkomponente (A) dispergierten Polymerpartikeln (C).

Das vorliegende Reaktionsharzsystem kann beispielsweise als Imprägnierharz, Lack oder als Vergussmasse eingesetzt werden. Die Verarbeitung erfolgt meist bei höherer Temperatur. Das Reaktionsharzsystem weist bei entsprechender Erwärmung eine so geringe Viskosität und eine so hohe Kapillarwirkung auf, dass auch ungünstige Geometrien wie Gießspalte mit einem Durchmesser von < 300 µm beim Verguss ausgegossen werden können. Dies ermöglicht gleichzeitig sehr kurze Taktzeiten. Das Reaktionsharzsystem wird bei Temperaturen zwischen 15 bis 280°C vernetzt.

Bei Verarbeitung als Imprägnierharz, beispielsweise zur Imprägnierung elektrischer Wicklungen, wird das Reaktionsharzsystem vorzugsweise mit einem Lösungsmittel, beispielsweise mit Styrol verdünnt, die zu imprägnierende Wicklung in Rotation versetzt und entweder in das flüssige Imprägnierharz eingetaucht oder es wird das flüssige Imprägnierharz auf die rotierende Wicklung aufgetropft. Die Aushärtung der imprägnierten Wicklung erfolgt beispielsweise thermisch oder über eine UVunterstützte Vernetzung.

Bei der Verarbeitung des Reaktionsharzes als Lack werden dem Reaktionsharzsystem Lösungsmittel zugegeben. Dabei kann es sich um übliche Lacklösungsmittel wie Toluol, Xylol etc. handeln.

Das Reaktionsharzsystem eignet sich in Abhängigkeit von seiner Polymerbasis im ausgehärteten Zustand auch für Bauteile, die zumindest zeitweise Temperaturen bis zu 300°C ausgesetzt sind, beispielsweise für Drahtlacke.

So kann das erfindungsgemäße Reaktionsharzsystem vorzugsweise zum Verguss von elektrischen oder elektronischen Bauteilen wie beispielsweise Dioden oder Zündspulen zum Einsatz kommen. Weiterhin können elektrische Wicklungen mit dem Reaktionsharzsystem imprägniert oder Leiterdrähte lackiert werden, sowie Leiterplatten und andere Laminate wie beispielsweise auch Sportgeräte hergestellt werden. Weitere vorteilhafte Ausführungsformen der vorliegenden Erfindungen finden sich in den Patentansprüchen.

## Patentansprüche

1. Härtbares epoxidfreies Reaktionsharzsystem, insbesondere Vergussmasse, Lack, Laminier- oder Imprägnierharz, das eine epoxidfreie Harzkomponente (A), einen mineralischen Füllstoff (B) und in der Harzkomponente (A) dispergierte Polymerpartikel (C) enthält, wobei der Füllstoff (B) Nanopartikel umfasst.

2. Reaktionsharzsystem nach Anspruch 1, **dadurch gekennzeichnet, dass** es als Einkomponentensystem zu verarbeiten ist.

3. Reaktionsharzsystem nach Anspruch 1 oder 2, **dadurch gekennzeichnet, dass** der Füllstoff Quarzmehl oder Quarzgutmehl enthält.

4. Reaktionsharzsystem nach einem der Ansprüche 1 bis 3, **dadurch gekennzeichnet, dass** der Füllstoff oberflächenmodifizierte Nanopartikel enthält.

5. Reaktionsharzsystem nach einem der vorhergehenden Ansprüche, **dadurch gekennzeichnet, dass** der Füllstoff Partikel zweier unterschiedlicher Korngrößenverteilungen d₅₀ aufweist, wobei eine Korngrößenverteilung im Nanometerbereich liegt.

6. Reaktionsharzsystem nach einem der vorhergehenden Ansprüche, **dadurch gekennzeichnet, dass** die Harzkomponente (A) zu einem Polymer mit Amid- oder Imidfunktionalitäten vernetzbar ist.

7. Reaktionsharzsystem nach einem der vorhergehenden Ansprüche, **dadurch gekennzeichnet, dass** die Harzkomponente (A) zu einem Polymer mit Carbonsäureesterfunktionalitäten vernetzbar ist.

8. Reaktionsharzsystem nach einem der vorhergehenden Ansprüche, **dadurch gekennzeichnet, dass** die Harzkomponente (A) ein Silikonharz, ein Cellulosederrivat, ein Vinylharz, ein Phenolharz und/oder ein Formaldehydharz enthält.

9. Reaktionsharzsystem nach einem der vorhergehenden Ansprüche, **dadurch gekennzeichnet, dass** die in der Harzkomponente (A) dispergierten Polymerpartikel (C) Silikonelastomerpartikel oder Elastomerpartikel eines Polyesters sind.

10. Reaktionsharzsystem nach Anspruch 8, **dadurch gekennzeichnet, dass** die Polymerpartikel (C) einen Teilchendurchmesser von 10 nm bis 100 µm aufweisen.

11. Verfahren zur Herstellung eines härtbaren Reaktionsharzsystems insbesondere nach einem der Ansprüche 1 bis 10, **dadurch gekennzeichnet, dass** in einem ersten Schritt Nanopartikel in der Harzkomponente (A) dispergiert werden und in einem zweiten Schritt die in der Harzkomponente (A) dispergierten Nanopartikel mit in der Harzkomponente (A) dispergierten Polymerpartikeln gemischt werden.

12. Verwendung eines Reaktionsharzsystems nach einem der Ansprüche 1 bis 10 zur Imprägnierung elektrischer Wicklungen.

13. Verwendung eines Reaktionsharzsystems nach einem der Ansprüche 1 bis 10 zum Verguss von Dioden und Zündspulen.

14. Verwendung eines Reaktionsharzsystems nach einem der Ansprüche 1 bis 10 zur Lackierung von Drähten.

15. Verwendung eines Reaktionsharzsystems nach einem der Ansprüche 1 bis 10 zur Fertigung von Sportgeräten.

## Claims

1. Curable, epoxide-free reactive resin system, especially encapsulating compound, enamel, laminating resin or impregnating resin, which comprises an epoxide-free resin component (A), a mineral filler (B) and, in dispersion in the resin component (A), polymer particles (C), the filler (B) comprising nanoparticles.

2. Reactive resin system according to Claim 1, **characterized in that** it is processed as a one-component system.

3. Reactive resin system according to Claim 1 or 2, **characterized in that** the filler comprises fine quartz powder or fine fused silica powder.

4. Reactive resin system according to one of Claims 1 to 3, **characterized in that** the filler comprises surface-modified nanoparticles.

5. Reactive resin system according to one of the preceding claims, **characterized in that** the filler contains particles of two different particle-size distributions d₅₀, one particle-size distribution being situated within the nanometer range.

6. Reactive resin system according to one of the preceding claims, **characterized in that** the resin component (A) can be crosslinked to a polymer containing amide or imide functionalities.

7. Reactive resin system according to one of the preceding claims, **characterized in that** the resin component (A) can be crosslinked to a polymer containing carboxylic ester functionalities.

8. Reactive resin system according to one of the preceding claims, **characterized in that** the resin component (A) comprises a silicone resin, a cellulose derivative, a vinyl resin, a phenolic resin and/or a formaldehyde resin.

9. Reactive resin system according to one of the preceding claims, **characterized in that** the polymer particles (C) in dispersion in the resin component (A) are silicone elastomer particles or elastomer particles of a polyester.

10. Reactive resin system according to Claim 8, **characterized in that** the polymer particles (C) have a particle diameter of 10 nm to 100 µm.

11. Process for preparing a curable reactive resin system in particular according to one of Claims 1 to 10, **characterized in that** in a first step nanoparticles are dispersed in the resin component (A) and in a second step the nanoparticles in dispersion in the resin component (A) are mixed with polymer particles in dispersion in the resin component (A).

12. Use of a reactive resin system according to one of Claims 1 to 10 for impregnating electrical windings.

13. Use of a reactive resin system according to one of Claims 1 to 10 for encapsulating diodes and ignition coils.

14. Use of a reactive resin system according to one of Claims 1 to 10 for enamelling wires.

15. Use of a reactive resin system according to one of Claims 1 to 10 for manufacturing sports equipment.

## Revendications

1. Système de résine réactive durcissable sans époxy, en particulier masse d'encapsulage, vernis, résine de laminage ou d'imprégnation, qui contient un composant résine sans époxy (A), une charge minérale (B) et des particules polymères (C) dispersées dans le composant résine (A), sachant que la charge (B) renferme des nanoparticules.

2. Système de résine réactive selon la revendication 1,
**caractérisé en ce qu'**
elle se met en oeuvre comme système à un composant.

3. Système de résine réactive selon la revendication 1 ou la revendication 2,
**caractérisé en ce que**
la charge contient de la poudre de quartz ou de la poudre de silice vitreuse.

4. Système de résine réactive selon l'une quelconque des revendications 1 à 3,
**caractérisé en ce que**
la charge contient des nanoparticules à surface modifiée.

5. Système de résine réactive selon l'une quelconque des revendications précédentes,
**caractérisé en ce que**
la charge présente des particules ayant deux répartitions granulométriques différentes d50, sachant qu'une répartition granulométrique est de l'ordre du nanomètre.

6. Système de résine réactive selon l'une quelconque des revendications précédentes,
**caractérisé en ce que**
le composant résine (A) peut être réticulé en un polymère ayant des fonctions amide ou imide.

7. Système de résine réactive selon l'une quelconque des revendications précédentes,
**caractérisé en ce que**
le composant résine (A) peut être réticulée en polymère ayant des fonctions ester d'acide carboxylique.

8. Système de résine réactive selon l'une quelconque des revendications précédentes,
**caractérisé en ce que**
le composant résine (A) contient une résine siliconée, un dérivé de cellulose, une résine vinylique, une résine phénolique et/ou une résine à base de formaldéhyde.

9. Système de résine réactive selon l'une quelconque des revendications précédentes,
**caractérisé en ce que**
les particules polymères (C) dispersées dans le composant résine (A) sont des particules d'élastomère siliconé ou des particules élastomères d'un polyester.

10. Système de résine réactive selon la revendication 8,
**caractérisé en ce que**
les particules polymères (C) présentent un diamètre de particule de 10 nm à 100 µm.

11. Procédé de fabrication d'un système de résine réactive durcissable en particulier selon l'une quelconque des revendications 1 à 10,
**caractérisé en ce que**
dans une première étape, on disperse les nanoparticules dans le composant résine (A) et, dans une deuxième étape, on mélange les nanoparticules dispersées dans le composant résine (A) aux particules polymères dispersées dans le composant résine (A).

12. Utilisation d'un système de résine réactive selon l'une quelconque des revendications 1 à 10, pour imprégner des enroulements électriques.

13. Utilisation d'un système de résine réactive selon l'une quelconque des revendications 1 à 10, pour encapsuler des diodes et des bobines d'allumage.

14. Utilisation d'un système de résine réactive selon l'une quelconque des revendications 1 à 10, pour vernir des fils.

15. Utilisation d'un système de résine réactive selon l'une quelconque des revendications 1 à 10, pour fabriquer des appareils de sport.
